# EUROPEAN PATENT APPLICATION

(11) **EP 4 836 299 A1**
(43) Date of publication of application: **04.11.2026**
(21) Application number: 25305629.5
(22) Date of filing: 30.04.2025
(51) Int. Cl.: H03K 17/18, G01R 31/27, G01R 31/28

(54) **COMPONENT AND MODULE FAILURE IDENTIFICATION METHOD, ASSOCIATED DEVICE AND GATE DRIVER AND COMPUTER PROGRAM**

(71) Applicant: Mitsubishi Electric R&D Centre Europe B.V., 1119 NS Schiphol Rijk Amsterdam (NL); MITSUBISHI ELECTRIC CORPORATION, Chiyoda-ku Tokyo 100-8310 (JP)
(72) Inventor: FOUBE, Laurent, 35708 RENNES CEDEX 7 (FR)
(74) Representative: Plasseraud IP

(57) **Abstract**

The disclosure relates to a gate driver (D1,... D4) comprising electronic components to act as an interface between a low-power controller (CTRL) and power semiconductor components (T1,...T4) and further comprising components for accepting a low-power input signal from the controller (CTRL) and generating a high-current drive for switch a gate of the high-power semiconductor component (T1,...T4) between two states (on/off), the gate driver (D1,... D4) further comprising components (DCC) to operate as a current injector and/or sensor to enable diagnostic of power semiconductor component (T1,...T4) to which it is connected when operating in a diagnostic mode. The disclosure also relates to a testing method using such a gate driver.

## Description

### Domain of the disclosure

The disclosure relates to the maintainability of electrical and electronic equipment. More particularly, the disclosure relates to a fault identification method for determining a malfunction of a module or component of an electrical or electronic device. The disclosure also relates to a gate driver and a device to perform the tests applied to the electrical or electronic device under test. More specifically the electrical or electronic device under test comprises at least one gate driver to perform the fault identification method, for determining the location of a faulty component or group of faulty components within the electronic or electrical circuit of the electrical or electronic device.

### Prior Art

While sustainability and ecodesign of product becomes a selection criterion in many situations, designing electric and electronic products that can achieve these objectives is increasingly hard.

Electronic products or systems (battery charging systems, motor drive inverters, HVAC, i.e. air conditioning systems, etc) are becoming increasingly complex, integrating one or more power electronic converters, themselves comprising numerous modules and components. These modules and components include, for example, electronic switches such as IGBTs (Insulated Gate Bipolar Transistors) or other power devices (MOSFET, i.e. Metal Oxide Semiconductor Field Effect Transistor, thyristors, diodes, etc), and passive components such as resistors, capacitors, transformers and inductors. Similarly, power electronics converters (such as DC to AC converters, i.e., inverters, DC to DC converters, synchronous rectifiers, etc.) can also include several (sub-)circuit boards, such as gate driver boards, EMI filter and controller board (including a DSP, or other kind of microprocessor, FPGA, etc.). These circuit boards themselves also include numerous electronic components (capacitors, resistors, electronic switches, power semiconductor components, transistors, integrated circuits for example). To make these power converters and possibly also sub-circuit boards "maintainable", we need to be able to identify which modules and/or components are faulty in the event of a fault. This identification must ultimately enable either the modules in question to be replaced, or the faulty components to be replaced (for example, by desoldering them and replacing them with new components).

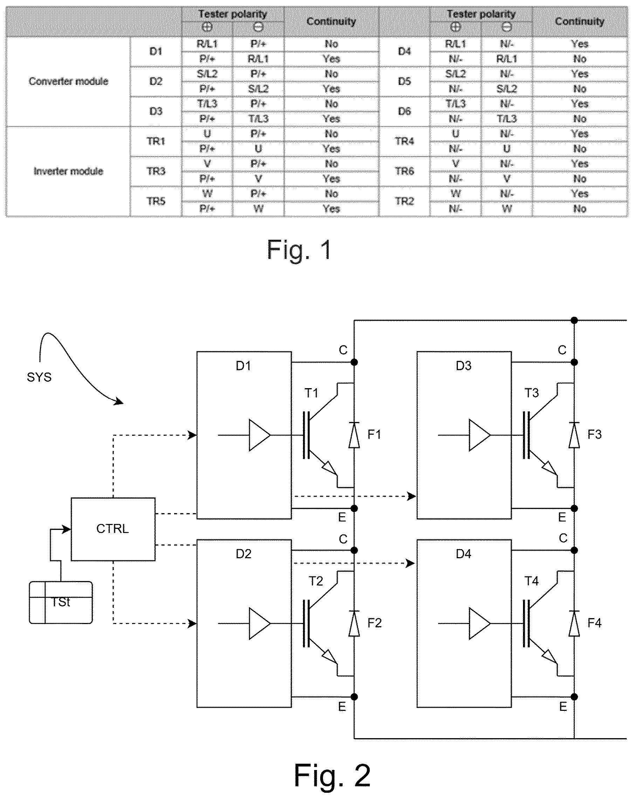

To date, the question of the maintainability of such electrical or electronic equipment is partly addressed by the provision, for some of this equipment, of a "data sheet" of tests to be carried out. For example, a paper or digital form details the series of manual tests to be carried out on the components of an electronic board (for example, a power electronics board) for determining which component or components may be faulty. Figure 1 shows, purely by way of illustration, such a data sheet for tests to be carried out on a simple inverter comprising only 6 diodes (free wheel diodes) and 6 transistors.

This methodology has several disadvantages, including: a bad scalability (since the process is only manual), a bad completeness (since test result might be caused by another fault than the considered one). The process is also time-consuming and presents a high risk of error (because of the manual definition and interpretation of the tests results). For example, relying on the example of figure 1, after performing the 24 required tests, two results may be expected:
- all the test results are according to the specification: one can conclude that there is no failure in the tested device, but there may be a failure elsewhere.
- at least one test result is not according to spec: one can conclude that there is a failure in the tested device, but also that there may be a failure elsewhere.

Consequently, these tests are not sufficient to repair the inverter with high confidence since they only address selected failures of the main power semi-conductors. In addition, there tests are numerous (24 tests in the example) and each require a specific connection of the diagnostic device.

Overall: the scalability and completeness are low; the test duration is high; the tests are difficult to automatize; the risk of test (performing or interpretation) error is high. Therefore, despite the presence of this test sheet, the repairability of the power electronic system is finally low.

The disclosure improves the situation.

### Summary of the disclosure

The disclosure allows solving at least part of the above problem.

The disclosure more specifically relates to a gate driver comprising electronic components to act as an interface between a low-power controller and power semiconductor components and further comprising components for accepting a low-power input signal from the controller and generating a high-current drive generating a high gate drive current required for change between two states (on/off) of high power semiconductor component, the gate driver further comprising components to operate as a current injector and/or sensor to enable diagnostic of power semiconductor component to which it is connected when operating in a diagnostic mode.

The arrangement of the gate driver with diagnostic capabilities allows for the detection of faults in power semiconductor components without the need for external diagnostic equipment. By integrating the current injection and sensing functions within the gate driver, the system can perform diagnostics in situ, reducing the need for manual testing and disassembly of components. This integration streamlines the maintenance process, allowing for quicker identification and resolution of faults, which is particularly beneficial in complex power electronic systems where access to individual components can be challenging.

According to the disclosure, the gate driver comprises a desaturation function and the sensor of the gate driver is made of the desaturation error pin of the associated desaturation function.

According to the disclosure, components enabling operating as a current injector comprises at least one additional input which, in combination with a switching input of the gate driver, enables configuring the gate driver in different operating modes.

According to the disclosure, the different operating modes are configurable at least by two switches belonging to the components enabling operating as a current injector.

According to the disclosure, the different operating modes belong to the group comprising:
- a regular mode, for normal operation of the power semiconductor component driven by the gate driver,
- a "passive 0" diagnostic mode in which the gate driver controls the power semiconductor component associated with a free-wheel diode under test,
- an "injection mode", used for diode test, or short circuit test.

According to the disclosure, in the "injection mode", the desaturation function is enabled while the output of the gate driver is configured to force the power semiconductor component in 'off' state, while input of gate driver is set to 'on' to enable desaturation function.

The disclosure also relates to a power electronics system. According to the disclosure, the power electronic system comprises at least a processor implementing a low-power controller for controlling at least one driver as previously exposed.

According to another aspect, the disclosures also relates to a power electronics system diagnostic method, the power electronic system comprising at least a processor implementing a low-power controller for controlling at least one driver, to control at least one high-power semiconductor component, the gate driver further comprising components to operate as a current injector and/or sensor to enable diagnostic of at least one power semiconductor component to which it is connected when operating in a diagnostic mode. The method comprises:
- loading, from a memory of the power electronics system, a set of tests to execute on the power electronics system, each test of the set of tests comprising at least:
   - a configuration of at least one component of the system that is implied in the test,
   - an identification piece of data of one gate driver that serves as a current injector during said test,
- sequentially executing at least one test of the set of tests as a function of the configuration of at least one component and the identification piece of data of one gate driver that serves as a current injector during said test,
- compiling results of the at least one test of the set of tests for providing a compiled result table in which the health of at least one tested component is provided.

According to the disclosure, sequentially executing the at least one test of the set of tests comprises, for a given test of the test set or of a test group:
- the controller configuring the at least one component of the system that is implied in the test according to its test configuration,
- the controller transmitting, to the component that serves as a current injector, a command to inject the current,
- the controller monitoring the results of the test.

According to the disclosure, configuring the at least one component comprising the controller transmitting, to the at least one component a command that puts the component in a desired operating mode. For example, 'on' or 'off' state, depending on its driver configuration (for gated power semiconductor components).

According to the disclosure, the tests of the set of tests are grouped in test groups and wherein, after sequentially executing at least one test of a test group of the test set, the method comprises discriminating the test results of the tests of the test group, discriminating comprising determining the actual health status of one or several components tested in said tests of the test group.

According to an aspect, the disclosure also relates to a method for testing using a set of test sequences and the interpretation of the test results to locate fault(s) in a power electrical or electronic system. According to an aspect, the disclosure also relates to an apparatus to implement the above method in an efficient (fast, robust, low-cost) way. Hence, such an apparatus may be sold as a software and hardware tool. According to an aspect, the disclosure also relates to a service in which the method and apparatus are used to identify the location of a fault prior to repairing the power electronic system. According to a feature, a fault identification method, for determining the location of a faulty component or group of faulty components within an electronic circuit, comprises iteratively applying a sequence of inputs (e.g. commanding activation of (power semiconductor) components by controlling gate drivers) from a test data structure.

According to a preferred implementation, the various steps of the methods according to the disclosure are implemented by one or more software or computer programs, comprising software instructions intended to be executed by a data processor of a relay module according to the disclosure and being designed to control the execution of the various steps of the methods.

Consequently, the disclosure also targets a program capable of being executed by a computer and/or a data processor, and/or integrated micro-controller of the system under test, this program comprising instructions for controlling the execution of the steps of a method as mentioned above. This program can use any programming language, and be in the form of source code, object code, or intermediate code. The disclosure also targets an information medium readable by a data processor, and comprising instructions of a program as mentioned above. The information medium can be any entity or device capable of storing the program, for example a storage means, a microelectronic circuit, or a magnetic or optical recording means. On the other hand, the information carrier may be a transmissible medium such as an electrical or optical signal, which may be conveyed via an electrical or optical cable, by radio or by other means. The program, according to the disclosure may in particular be downloaded from a network such as the Internet. Alternatively, the information carrier may be an integrated circuit in which the program is incorporated, the circuit being adapted to execute or to be used in the execution of the method in question. According to one embodiment, the disclosure is implemented by means of software and/or hardware components. With this in mind, the term "module" may correspond in this document to a software component, a hardware component or a set of hardware and software components. Each component of the system described above of course implements its own modules. The different embodiments mentioned above can be combined with each other for the implementation of the disclosure.

### Description of Drawings

Other features and advantages of the disclosure will appear more clearly on reading the following description of an embodiment of the disclosure, given as a simple illustrative and non-limiting example, and the appended drawings among which:
- Figure 1 already presented, shows a simple example of a fault detection data sheet, with module device numbers and terminal to be checked,
- Figure 2 illustrates a simplified example of an electronic circuit according to the disclosure,
- Figure 3 illustrates an enhanced gate driver according to the disclosure,
- Figure 4 illustrates the steps of the fault identification method according to the disclosure.

### Description of an embodiment

As previously exposed, the disclosure addresses the problem of diagnostic of power semiconductors including the FWD diodes with automatic tests. The disclosure is more specifically directed to an "enhanced" gate driver. A gate driver is a power amplifier that accepts a low-power input from a controller IC and produces the appropriate high current gate drive for a power semiconductor component. Power semiconductor components are for example gated semiconductor components such as IGBTs or MOSFETs or other "ordinary" transistors used as switching elements (FETs, BJTs for instance) for example in switched-mode power supplies (SMPS), universal power supplies (UPS) and motor drives.

Fig. 2 is an illustrative schematic example of an electrical / electronic board of a system under test. In this illustrative example, the board comprises four gate drivers (D1,...D4) commanding the states of four power semiconductor components (T1, ... T4) (here IGBT are represented) with their FWD (F1,...F4). In this illustrative example, for clarity purposes, it is considered that each driver is an enhanced gate driver according to the disclosure, meaning that each driver has (when put in a "diagnostic mode" of the system), the capability of injecting current at the collector (C) to be looped to the Emitter (E) or Kelvin Emitter (KE), depending on the nature of the component. According to the disclosure, the drivers (D1,...D4) are at least partially controlled by a controller CTRL. This is represented by dashed lines. The controller CTRL of the disclosure, among other tasks comprises functionalities for conducting diagnostic tests of the power semiconductor components and, in this context the free-wheel diodes (associated to IGBTs (and MOSFETs)). For achieving these test functions, the controller CTRL comprises a test loading module which loads test sets TSt from a memory of the system. A test, in a set of tests TSt, comprises:
- A status of each of the components of the set of components (open/closed in case of the four power semiconductor components (T1, ... T4) for example),
- An identification of the controlled power semiconductor components (e.g. the "power switch" for which the Desaturation error is to be tested) or an identification of the driver which controls the components, depending on the configuration,
- Other configuration parameters (e.g. duration of each test, voltage, current intensity, etc.).

More specifically, about voltage parameter, a minimum voltage value is set. This minimum voltage value is set to a value superior to the threshold voltage value for the desaturation protection function of the power semiconductor component. Indeed, the system is powered with the alternative power supply (low voltage as set in the parameter, current limited to enable DC bus short circuit) for the testing purposes. For example, in the event the desaturation protection function is 8-9v, the voltage parameter is set at 10v. In some cases, a check of the actual voltage provided by the alternative power supply is done in accordance with the requirements for the tests of the power semiconductor components.

When the system is turned in "diagnostic mode", the set of tests can be launched (after for example the main load of the electronic or electrical board of the system is disconnected and the alternative power supply is connected). The controller then loads the set of tests and launches sequentially all or part of the tests of the set of tests. The controller configures the components according to their status (e.g. opened or closed for example). Once configured according to the test to conduct, the selected enhanced gate driver injects the current to the collector. In the presence of an error (short circuit, open circuit, depending on the configuration and the test itself) an error is raised (this may be a desaturation error as explained below). The presence of the desaturation error indicates that the test did not perform correctly. From the configuration (status of each of the components of the set of components), the nature of the failure may be deduced. Several tests' examples are explained below.

Hence, according to the disclosure, instead of requiring manual testing or using external devices to perform the tests, it is made use of internal enhanced (gate) drivers of an electrical or electronic device (e.g. power converter) and specific test sequences to diagnose these components. In addition, the test sequences also allow to determine if the power semiconductor components (e.g. IGBTs, MOFSET, etc.) are in open or short circuit state. With the proposed technique, there is less disassembly since the diagnostic can be performed by internal controller and taking benefit of integrated hardware (e.g. enhanced gate drivers, and optionally other hardware such as controllable components, existing sensors, etc.).

Human intervention is to enable the tests and require a limited number of connection/disconnection operations in the electronic or electrical system or device. Once in diagnostic mode, the controller CTRL of the electronic or electrical system or device performs the various tests sequences automatically (i.e. the diagnostic of different semiconductors). The disclosure thus provides a technique that allows performing diagnostic with less human intervention requirement, reducing the time needed to perform diagnostic while improving the test coverage with reduced risks of error. The diagnostic method uses the enhanced (gate) driver that allows to inject a test current and to check that some low impedance path exists between injection point (e.g. point connected to "collector" or "drain" of the power semiconductor components) and reference point (e.g. point connected to "emitter" or "kelvin emitter" of the power semiconductor components). The use of such driver in a power converter makes diagnostic of power semiconductors possible.

The use of the enhanced gate drivers in conjunction with test sequences to diagnose the different power switches and associated free wheel diodes FWD is exemplified in following sections. The tests (comprising the test sequences) are typically applied during service/maintenance of a system under test (e.g. a part of a motor drive, the inverter stage for instance) and can be applied by the controller of a device of this system (e.g. the power converter) while this later is configured for diagnostic operation. As a function of the systems under test, some manual intervention might be needed, such as disconnection from load, possibly from DC bus (section connected to capacitors & rectifier outputs), need for powering of converter's controller despite the DC bus is not powered which is justified since the tests might create short circuit of the bus during some tests or because of the failure of some element(s).

While a test configuration is required, one significant advantage is that the electronic board (the inverter part for example) does not need to be removed from the equipment for diagnostic.

In consequence, the disclosure is directed to an enhanced gate driver which allows performing diagnostic on the controlled device and, in coordination with other gate drivers of the system under test, to diagnose other elements (e.g. other gate drivers or other power semiconductor components) in power converter, including the test of FWD *(also called body diodes, free-wheel, or anti-parallel diodes)* of power switches. The enhanced gate driver acts as injector/sensor during service/maintenance operation. The word "injector" is used (instead of "stimulator") since a test current is injected in the diagnostic mode of operation.

According to the disclosure, the enhancement (of the driver) is made directly to a gate driver with a desaturation function. This gate driver is modified so that it can be used to detect off-line some kind of faults (switch open fault or disconnected from driver) and enables diagnostic of diode. In another example embodiment, the injection part is implemented, on a conventional driver (i.e. a driver that does not have a desaturation function), using additional electronic components to implement a current source as well as the logic for the sensing part. The advantage of using a driver with a desaturation function is that the modification to implement are simpler than in the case of a conventional driver. The desaturation detection function is normally a safety/protection function used to protect against short-circuit during operation. When using this function, the enhanced gate driver enables to use this feature for testing purpose, with some minor modifications of the driver to behave specifically during test sequences.

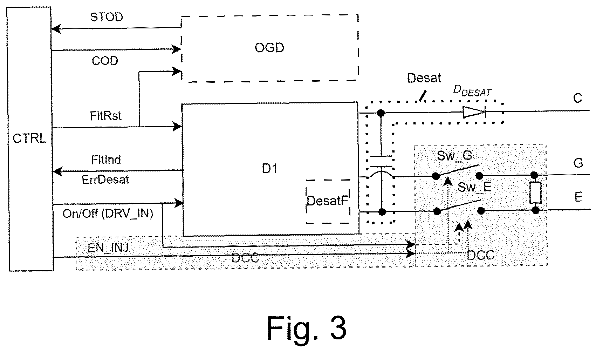

Fig. 3 illustrates a broad view of the enhancement of the gate driver according to an example embodiment. The illustrated gate driver of Fig. 3 already comprises a desaturation function. On Fig. 3: STOD stands for "Status of other drivers", OGD stands for "Other gate drivers", COD stands for "commands of other switches", FltRst stands for "Reset fault", Fltlnd stands for "Fault indication".

On this illustrated gate driver, diagnostic enabling components (DCC - in gray dashed box) are added to allow the use of the desaturation function to perform tests. The added components comprise two switches (to control connections between driver and IGBT) and a pull-down resistor (between connection point to G and E (to ensure blocked state when at least one of switches Sw_G or Sw_E is opened)). These switches enable different mode of operation of driver depending on inputs of driver (DRV_IN, EN_INJ). In some implementation, those switches Sw_G or Sw_E can be implemented using different technologies (for instance small relays, or low power MOSFETs).

Hence, two additional operative modes are added: 'injection' and 'passive 0'.

Injection mode is the main objective of the enhanced gate driver: it allows that driver to act as a current injector and sensor: specifically, in this mode it detects whether or not there is a low impedance path between C & E of controlled power semiconductor component (IGBT). Such low impedance path exists if a "path" within the converter is established through some switches or diodes so that current delivered to C can return to E (and thus gate driver). More specifically, in the injection mode, the test current (Idesat) is provided by the driver to the Collector of IGBT. At the same time this current source can charge the desat capacitor if the current Idsat cannot flow through the IGBT or through other connected elements forming a loop to the driver. If the capacitor receives some current it will charge, and its voltage (Vcdesat) increase up to the point that voltage exceeds the threshold and error is activated. On the other hand, if a low impedance path exists between C & E through the circuit, the voltage across desat capacitor is clamped (i.e. bounded) to the value of ~Vce. If Ddesat conducts (meaning there exists a low impedance path between C & E, i.e. Vce < Vthreshld + voltage drop across Ddesat, the capacitor voltage does not reach threshold voltage and error is not activated. In this Case (error not activated), it is considered that the component(s) on the path either work(s) correctly, or at least no component is in open circuit or not controllable. The path to "test" is determined by a configuration of the test.

If this is not the case (no path), Vcdesat will reach the threshold, triggering the error.

The modification of desaturation protection function so that it performs the intended function (operating mode "injection") requires:
- to enable the desaturation protection function (set drv_in=1 since it operates only when driver is on);
- to keep the controlled power semiconductor componentin off state (since it is not intended to provide a low impedance path between C&E though the controlled power semiconductor component itself).

Another modification is made to avoid that injected current flows through the driver connected to device under test, instead of through the desired tested device (mode called here "passive 0" mode).

The operative modes are summarized in the following table:

| DRV_IN | EN_INJ | Sw_G | Sw_E | Operation of driver | comment |
|---|---|---|---|---|---|
| 0 | 0 | on | on | "active" 0 (normal operation) | G & E connected normal "off" command of IGBT |
| 0 | 1 | off | off | "Passive" 0 (for the power comp. under test) | G & E disconnected: IGBT "Off" due to output pull down No current can flow through driver (only though diode!) |
| 1 | 0 | on | on | "active" 1 (normal operation) | G & E connected: normal "on" command of IGBT |
| 1 | 1 | off | on | "injection" (driver used as injector/tester) | G disconnected: the driver "believes" it drives '1' and acts as injector / desaturation protection is activated |

One can note that Sw_E (only off in "passive" 0) is added as a way to prevent a current entering the connection to Emitter to flow through the driver itself (it is supposed to flow only within the diode under test between emitter and collector). This is interesting for example for diode tests, since it allows prevent some reverse current to flow within gate driver in that case.

As an alternate embodiment that switch might be placed in series with Ddesat (to interrupt link to collector, i.e. disconnect the link used for desaturation protection). There is no need in that case to interrupt connection to emitter (driver reference point directly connected to E, no Sw_E). In that case there is no need for a "passive 0": active "0" is used instead for the diode test (with Sw_G on).

It can also be noted that while not shown on the figures, the logic is powered by the (usually) isolated driver power supply VDRV. Some isolation (opto isolation, capacitive) is typically required on signals EN_INJ and DRV_IN.

Other implementation alternative(s) can also be used to force the power semiconductor component in "off" state during the tests: an active pull down can be used for instance.

In some implementations, modification of gate driver integrated circuit can be envisioned. In this context, there are quite a lot of degree of freedom here: an input might be added (EN_INJ) to explicitly put the driver in injection mode (i.e. with output forced to "off" state but with protection function enabled). Integration of additional logic or (low power) switches such as Sw_E is quite easy in an integrated circuit. Moreover, if the driver integrated circuit has integrated signal isolation, it removes the need for additional isolation of signal, for DRV_IN for instance.

As mentioned above, with an electronic board comprising one or several of these enhanced gate drivers, sequential tests can be performed according to test sets that have been prerecorded in the memory of the device. Each test of the set of tests has a dedicated goal which depends entirely on the configuration of the board of the device. Hence the diagnostic method comprises the execution of these tests, in an automated manner, once the system is switched in "diagnostic" mode (and that the system is physically in "diagnostic" mode).

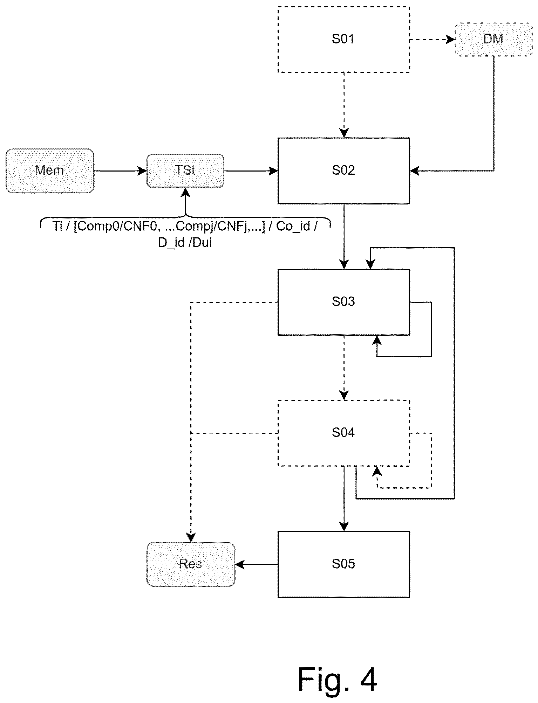

Fig. 4 illustrates the diagnostic method. The method comprises the steps of:
- optionally determining S01, by the controller CTRL, that the power electronics system SYS is in diagnostic mode DM,
- loading S02, from the power electronics system SYS memory Mem, the set of tests to execute on the power electronics system SYS, each test Ti of the set of tests TSt comprising at least:
   - a configuration CNFj of at least one component COMPj of the system that is implied in the test Ti,
   - an identification CO_id of one enhanced gate driver D_id that serves as a current injector during said test,
   - optionally a duration Dui of said test Ti, the duration representing time during which the current injection is made.
- sequentially executing S03 at least one test Ti of the set of tests comprising:
   - the controller CTRL configures the at least one component COMPj of the system that is implied in the test Ti according to its test configuration CNFj, the configuration comprising notably for example the CTRL transmitting, to the at least one component COMPj a command that puts the (controlled) component in a desired state (for a power switch, e.g. IGBT, "active "0", "active "1", passive "0" or « injection mode » -since the device under test can also be associated with the driver in injection mode-, or a relay put in conduction, etc.),
   - the controller CTRL transmitting, to the gate driver that serves as a current injector, a command to inject the current during the duration Dui of said test Ti,
   - the controller CTRL monitoring the results of the test Ti, in examples monitoring comprises receiving an indication of a fault presence from one or several components of the of at least one component COMPj of the system that is implied in the test Ti, the indication may come from the desaturation error of the enhanced gate driver.

In some example embodiments, the tests of the set of tests TSt may be grouped by categories (categories by components to be tested, e.g. IGBT, diodes, etc.) and additional steps of diagnostic may be performed as a function of unitary tests that are executed on single or groups of components. These additional steps of diagnostic may for example be discriminating steps which have the objective of solving uncertainty regarding the health of some components. Hence sequentially executing S03 the at least one test Ti of a group of tests of the set of tests may be followed by a discriminating S04 step which comprises determining the actual health status of one or several components. Then, before sequentially executing S03 the next group of tests (among the set of tests), the method may comprise eliminating, from said next group of tests, the tests that involve configuring one or several of the components that have been determined as being non healthy or dysfunctional.

In some cases, as the one exposed below in example, a final compilation step S05 can be performed for eventually, as a function of the successive executions S03 and discriminating S04, determine which of the various tested components are working and which ones have to be replaced. At the end of the execution of the set of tests, a compiled result table RES, that can be for example displayed or transmitted, is obtained.

In the following paragraphs, examples of the sequential execution of the tests of a set of tests are disclosed. In this example, the set of tests comprises two groups and the tests are performed on a power converter (the system) in which power semiconductor components (for instance IGBTs), like the ones illustrated in figure 1, are tested.

The diagnostic method can comprise the following successive execution S03, S04 of tests:
1) the first step, implying a first group of tests comprises: identification of open/short circuit state of power semiconductor components in the system, comprising for example:
   a) identification of possible open faults (with some uncertainties),
   b) identification of possible short faults (with some uncertainties),
   c) combination of two previous steps to decide on open/fault state (resolution of uncertainties).
2) the second step implying a second group of tests comprises: diode open tests of each FWD of the system (with some uncertainties),

The last step, which corresponds to the final discrimination test S05, comprises the combination of results of the two previous steps to determine the state of health of the different power semiconductor components (tested) within the system.

Each of these steps is detailed below in connection with the test of power semiconductor components of a power converter. This can of course be extended to other situations or devices which have similar architecture and/or components.

### 1) First step: Open circuit / short circuit detection of power semiconductor components

In this example, the determination of the open and short circuit state of each power semiconductor component requires to combine the results of different test sequences to remove some uncertainties on the exact state of the device. This can be described as three sub-steps:

### a) test of open circuit

The identification of open faults is carried out by successively activating, i.e. turning on, the different power semiconductor components (typically one single power semiconductor component "on" at a time). Drivers are configured for normal operation, with desaturation protection function. After each power semiconductor component turn-on, the state of error indication is checked:
- if error is activated (1), the corresponding power semiconductor component is open
- otherwise (0), the power semiconductor component is not open but might be in short circuit (this only test is not sufficient to decide the actual state).

A reset of the error might be required between two successive power semiconductor component tests to clear the desaturation error of driver (can be done systematically).

### b) test of short circuit

By using the enhanced gate drivers, it is possible to detect short circuits of each power semiconductor component individually. The drivers "on" during that test are configured in diagnostic (injector/test) mode. The identification is done by successively activating, typically one at a time, the power semiconductor components of the power converter. After each turn on, the state of error indication is checked:
- if error is not activated (0), the corresponding power semiconductor component is in short circuit,
- otherwise (1), the power semiconductor component is not in short circuit, i.e. open, which can be normal or due to an open circuit fault (there is an ambiguity there).

Here again a reset of desaturation error can be done after each power semiconductor component test.

### c) combination of previous sub-steps (a&b) to resolve the uncertainties / ambiguities

By performing logical operations between the two previous results, it is possible to decide the exact state of the different devices. The rule is the following. By naming tst_oc_res (for one current power semiconductor component) the test result (state of error indicator) of an open circuit test (step a), tst_sc_res (for the current power semiconductor component) the test result of a short circuit test (step b) (i.e. the state of error indicator of driver associated to device tested, following each test):

| | |
|---|---|
| - the power semiconductor component is in open-circuit if: tst_sc_res=1, | tst_oc_res=1 and |
| - the power semiconductor component is ok if: tst_sc_res=1, | tst_oc_res=0 and |
| - the power semiconductor component is in short circuit if: tst_sc_res=0. | tst_oc_res=0 and |

Which can be summarized in the following truth table:

| State of error indicator after OC test (tst_oc_res) | State of error indicator after SC test (tst_sc_res) | Diagnostic on state of power semiconductor component (PSC) |
|---|---|---|
| 0 (PSC not open) | 0 (PSC short circuit) | Short circuit |
| 0 (PSC not open) | 1 (not in short circuit) | ok |
| | | (impossible) |
| 1 (PSC open) | 1 (not in short circuit) | Open circuit |

Hence, these first steps allow obtaining the "health" status of each power semiconductor component of the circuit, and applying the segregation rules detailed above to solve uncertainty for each of the power semiconductor component. These first results are stored in a data structure of the controller for example.

### 2) Second step: "diode" test of each FWD of the power converter

Illustration of test method for FWD diode diagnostics of IGBTs in inverter (presented for a two legs inverter - can be generalized to N legs).

The test procedure consists in establishing a path within power converter which is expected to be closed if element under test is "not open" (under assumption that other components are either good or in short circuit, which justifies the previous steps).

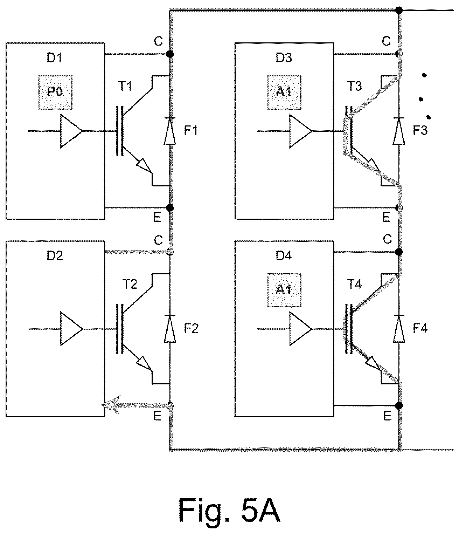

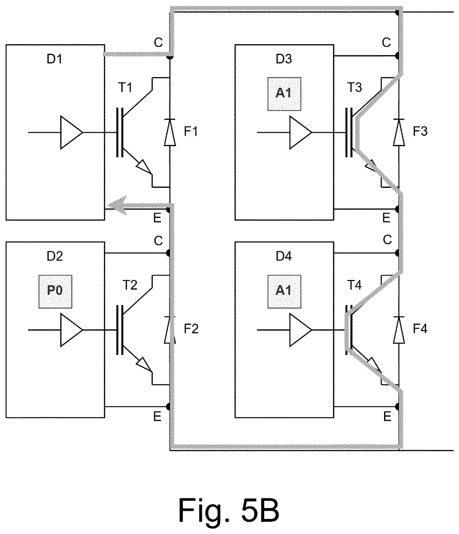

By combining different test sequences, each device in the loop can be checked independently. A systematic approach can be applied to check the state of each diode in the loop. This is illustrated in fig. 5A and fig. 5B for the diagnostic of two power semiconductor components (IGBT for instance) within a leg. The same principles apply to other legs by permutating the role of the different drivers. In fig. 5, two tests are performed. The tests seek to check whether an FWD of two power semiconductor components (F1 and F2) are opened or not in one leg. For clarity purposes, the same elements of figure 2 are used in these figures 5A and 5B. For the first test (Fig. 5A), commands are transmitted by the controller (not shown) to the drivers D1, D3 and D4 to put their associated power semiconductor components (T1, T3, T4) in a predetermined state (opened or closed, marked by "P0" (passive 0) or "A1" (active 1 - i.e. classic active state) on the figure unlabeled driver D2 is the injector). The enhanced gate driver D2 is used as the current injector and the possible error is detected by the desaturation error received from this enhanced gate driver D2. The flow of the injected current is illustrated by the bold line. In this test, since power semiconductor component T1 is closed (passive "0" (i.e. P0 in figs) the current flow indicates that the diode F1 is passing.

For the first test (Fig. 5B), commands are transmitted by the controller (not shown) to the drivers D2, D3 and D4 to put their associated power semiconductor components (T2, T3, T4) in a predetermined state (opened or closed, marked by "P0" or "A1" on the figure, unlabeled driver D1 is the injector). The enhanced gate driver D1 is used as the current injector and the possible error is detected by the desaturation error received from this enhanced gate driver D1. The flow of the injected current is illustrated by the bold line. In this test, since power semiconductor component T2 is closed (0) the current flow indicates that the diode F2 is passing.

Hence, a short circuit is established between DC+ and DC- though at least one other leg. The state of health of the diode under test is assessed by considering the state of "err_desat" (of the injecting driver, injector) after each test. As shown on Figs. 5A and 5B, if "err_desat" (of injector) is asserted after a test, it means that diode of the tested power semiconductor component is open (otherwise it is not opened, but it might be due to the power semiconductor component's short circuit). All other legs can be placed in short circuits (provide additional paths if some components are open in one leg). If a power semiconductor component in another leg is in "open fault" state, this leg will not be usable to perform bus short circuit: another leg might be used for that purpose (if that makes sense: if all components belong to a single power module, the latter will have to be replaced and the diagnostic of its other power semiconductor components might be not relevant/useful).

Finally, after the execution of this group of tests, the controller CTRL possesses health status of each diode of the circuit.

### 3) Third step: combination of results of the two previous steps (1&2) to determine the states of health of the different tested components within the power converter.

That step is (optionally) used to remove the ambiguity on exact state of diode when previous step has concluded that a diode is not open. Check that associated power semiconductor component is (or not) in short circuit allows to remove ambiguity as follows:
- If the diode is not open and the associated power semiconductor component is not in short-circuit: the diode is working,
- If diode is not open and associated power semiconductor component is in short circuit: the diode is considered in short circuit (not possible to determine which of the power semiconductor component or the diode is in short circuit).

At the end of that step, a matrix of the "health state" of different tested components is obtained: ok, open circuit, short circuit. This matrix can be sent, by the controller, in the form of a file, to a dedicated receiver. In other situations, this matrix can be displayed on a screen of the power converter.

## Claims

1. A gate driver (D1,... D4) comprising electronic components to act as an interface between a low-power controller (CTRL) and power semiconductor components (T1,...T4) and further comprising components for accepting a low-power input signal from the controller (CTRL) and generating a high gate drive current required for change between two states (on/off) of high power semiconductor component (T1,...T4), the gate driver (D1,... D4) further comprising components (DCC) to operate as a current injector and/or sensor to enable diagnostic of power semiconductor component (T1,... T4) to which it is connected when operating in a diagnostic mode.

2. The gate driver (D1,...D4) of claim 1 comprising a desaturation function (DesatF) and wherein the sensor of the gate driver (D1,...D4) is made of the desaturation error pin (Fltlnd, ErrDesat) of the associated desaturation function (DesatF).

3. The gate driver (D1,...D4) of claim 1 or 2, wherein components (DCC) enabling operating as a current injector comprises at least one additional input (EN_INJ) which, in combination with a switching input (DRV_IN) of the gate driver (D1,...D4), enables configuring the gate driver (D1,...D4) in different operating modes.

4. The gate driver (D1,...D4) according to claim 3, wherein the different operating modes are configurable at least by two switches (Sw_G, Sw_E) belonging to the components (DCC) enabling operating as a current injector.

5. The gate driver (D1,...D4) according to claim 3 or 4, wherein the different operating modes belong to the group comprising:
- a regular mode (active 0, Active 1), for normal operation of the power semiconductor component (T1,...T4) driven by the gate driver (D1,...D4),
- a "passive 0" diagnostic mode in which the gate driver (D1,...D4) controls the power semiconductor component associated with a free-wheel diode under test,
- an "injection mode", used for diode test, or short circuit test.

6. The gate driver (D1,...D4) according to claim 5 combined with claim 2, wherein in the "injection mode", the desaturation function (DesatF) is enabled while the output of the gate driver (D1,...D4) is configured to force the power semiconductor component (T1,...T4) in 'off' state, while input of gate driver is set to 'on' (DRV_IN=1) to enable desaturation function (DesatF).

7. A power electronics system (SYS), the power electronic system comprising at least a processor implementing a low-power controller (CTRL) for controlling at least one driver (D1,... D4) according to any of claims 1 to 6.

8. A power electronics system (SYS) diagnostic method, the power electronic system comprising at least a processor implementing a low-power controller (CTRL) for controlling at least one driver (D1,... D4), to control at least one high-power semiconductor component (T1,...T4), the gate driver (D1,... D4) further comprising components (DCC) to operate as a current injector and/or sensor to enable diagnostic of at least one power semiconductor component (T1,...T4) to which it is connected when operating in a diagnostic mode, the method comprising:
- loading (S02), from a memory (Mem) of the power electronics system (SYS), a set of tests (TSt) to execute on the power electronics system (SYS), each test (Ti) of the set of tests (TSt) comprising at least:
- a configuration (CNFj) of at least one component (COMPj, T1,...T4) of the system that is implied in the test (Ti),
- an identification piece of data (CO_id) of one gate driver (D_id) that serves as a current injector during said test,
- sequentially executing (S03) at least one test (Ti) of the set of tests as a function of the configuration (CNFj) of at least one component (COMPj, T1,...T4) and the identification piece of data (CO_id) of one gate driver (Di) that serves as a current injector during said test,
- compiling (S05) results of the at least one test (Ti) of the set of tests for providing a compiled result table (RES) in which the health of at least one tested component is provided.

9. The method according to claim 8, wherein sequentially executing (S03) the at least one test (Ti) of the set of tests comprises, for a given test (Ti):
- the controller (CTRL) configuring the at least one component (COMPj, T1,...T4) of the system that is implied in the test (Ti) according to its test configuration (CNFj),
- the controller (CTRL) transmitting, to the component that serves as a current injector, a command to inject the current,
- the controller (CTRL) monitoring the results of the test (Ti).

10. The method according to claim 9, wherein configuring the at least one component (COMPj, T1,...T4) comprising the controller (CTRL) transmitting, to the at least one component (COMPj, T1,...T4) a command that puts the component in a desired operating mode.

11. The method according to any of claim 8 to 10, wherein the tests of set of tests (TSt) are grouped in test groups and wherein, after sequentially executing (S03) at least one test of a test group of the test set, the method comprises discriminating (S04) the tests results of the tests of the test group, discriminating (S04) comprising determining the actual health status of one or several components (COMPj, T1,...T4) tested in said tests of the test group.

12. Computer program product comprising instructions which, when executed by at least one processor, configure said at least one processor to carry out a method according to any one of claims 1 to 11.
